(19) **Europäisches Patentamt** **European Patent Office** **Office européen des brevets**

(11) **EP 4 386 864 B1**

(12) **EUROPEAN PATENT SPECIFICATION**

(45) Date of publication and mention
of the grant of the patent:
**04.06.2025 Bulletin 2025/23**

(51) International Patent Classification (IPC):
*H10F 77/30* (2025.01)    *H10F 10/14* (2025.01)
*H10F 10/166* (2025.01)    *H10F 71/00* (2025.01)

(21) Application number: **23196106.1**

(22) Date of filing: **07.09.2023**

(52) Cooperative Patent Classification (CPC):
**H10F 10/166; H10F 10/14; H10F 71/121;
H10F 77/311**

(54) **SOLAR CELL AND PHOTOVOLTAIC MODULE**

SOLARZELLE UND FOTOVOLTAISCHES MODUL

CELLULE SOLAIRE ET MODULE PHOTOVOLTAÏQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **14.12.2022 CN 202211603377**

(43) Date of publication of application:
**19.06.2024 Bulletin 2024/25**

(73) Proprietor: **Zhejiang Jinko Solar Co., Ltd.
Haining, Zhejiang 314416 (CN)**

(72) Inventors:
• **LIU, Changming
Yuanhua Town, 314416 (CN)**

• **JIN, Jingsheng
Yuanhua Town, 314416 (CN)**
• **ZHANG, Bike
Yuanhua Town, 314416 (CN)**
• **ZHANG, Xinyu
Yuanhua Town, 31446 (CN)**

(74) Representative: **Spachmann, Holger
Stumpf Patentanwälte PartGmbB
Alte Weinsteige 73
70597 Stuttgart (DE)**

(56) References cited:
**CN-A- 114 823 951    KR-A- 20160 111 624
US-A1- 2016 005 900    US-A1- 2022 140 160**

## Description

## TECHNICAL FIELD

The present disclosure relates to the photovoltaic technical field, and in particular, to a solar cell and a photovoltaic module.

## BACKGROUND

A solar cell can directly convert solar radiation energy into electrical energy, based on a photovoltaic effect of crystalline silicon. When photons of sunlight are absorbed by the crystalline silicon, electron-hole pairs may be generated. The electrons and holes, when arriving at a p-n junction composed of p-type crystalline silicon and n-type crystalline silicon, are respectively separated to two sides of the p-n junction by a junction electric field. When the solar cell is connected to an external load, a photocurrent current is generated, and electric energy is outputted. In actual use, solar cells are generally connected in series/parallel and then packaged together to form a photovoltaic module.

The solar cell further includes doped polysilicon, and the doped polysilicon may absorb light, which reduce the photoelectric conversion efficiency of the solar cell. In order to reduce the light absorption capability of the doped polysilicon and increase the photoelectric conversion efficiency of the solar cell, a thickness of the doped polysilicon is generally reduced. However, the thinner doped polysilicon has a large lateral transport resistance and an increased carrier recombination probability, so the reduction in the thickness of the doped polysilicon reduces the photoelectric conversion efficiency of the solar cell.

US2022140160A1 teaches a solar cell including: a substrate, a tunneling layer formed on the back surface of the substrate, a retardation layer formed on the tunneling layer, a field passivation layer spaced apart from the tunneling layer by the retardation layer, a second passivation film formed on the field passivation layer, and a back electrode. The retardation layer prevents doped ions in the field passivation layer from migrating into the substrate.

## SUMMARY

Embodiments of the present disclosure provide a solar cell and a photovoltaic module. The solar cell has a reduced transverse resistance and increased recombination due to a thinner first doped conductive layer, thereby improving photoelectric conversion efficiency of the solar cell.

The present disclosure provide a solar cell. The solar cell includes a body and a first electrode. The body has a first region and a second region. Along a thickness direction of the solar cell, at least part of the first region covers the first electrode. The second region is a region of the body other than the first region. The body includes a substrate, a first tunneling layer, a first doped conductive layer, and a second doped conductive layer. The first tunneling layer is arranged on a side of the substrate, and the first tunneling layer has a greater thickness in the first region than in the second region. The first doped conductive layer is arranged on a surface of the first tunneling layer away from the substrate, and the first electrode is electrically connected to the first doped conductive layer. The second doped conductive layer is located on a side of the substrate adjacent to the first tunneling layer, and the second doped conductive layer has a lower thickness in the first region than in the second region. The dopant element in the second doped conductive layer is from the first doped conductive layer.

In one or more embodiments, the first tunneling layer in the first region protrudes towards the first doped conductive layer with respect to the first tunneling layer in the second region, and the second doped conductive layer in the second region protrudes towards the substrate with respect to the second doped conductive layer in the first region.

In one or more embodiments, the first tunneling layer in the first region protrudes towards the substrate with respect to the first tunneling layer in the second region, and the second doped conductive layer in the second region protrudes towards the first doped conductive layer with respect to the second doped conductive layer in the first region.

In one or more embodiments, in the second doped conductive layer, doping concentration of a dopant element in the first region is less than that in the second region.

In one or more embodiments, the doping concentration $c1$ of the dopant element in the first region of the second doped conductive layer satisfies: $1 \times 10^{18}$ atoms/cm$^3 \leq c1 \leq 1 \times 10^{20}$ atoms/cm$^3$.

In one or more embodiments, the doping concentration $c2$ of the dopant element in the second region of the second doped conductive layer satisfies: $1 \times 10^{19}$ atoms/cm$^3 \leq c2 \leq 2 \times 10^{20}$ atoms/cm$^3$.

In one or more embodiments, a thickness $H11$ of the first tunneling layer in the first region satisfies: $1$ nm$\leq H11 \leq 2.5$ nm.

In one or more embodiments, a thickness $H12$ of the first tunneling layer in the second region satisfies: $0.5$ nm$\leq H12 \leq 2$ nm.

In one or more embodiments, a thickness $H21$ of the second doped conductive layer in the first region satisfies: $0$ $\mu$m$\leq H21 \leq 0.5$ $\mu$m.

In one or more embodiments, a thickness $H22$ of the second doped conductive layer in the second region satisfies: $0$ $\mu$m$\leq H22 \leq 1$ $\mu$m.

In one or more embodiments, the first region is arranged alternately with the second region along a width direction of the solar cell.

In one or more embodiments, along a width direction of the solar cell, a width $D1$ of the first region

satisfies: 10 $\mu$m$\leq$ D1 $\leq$200 $\mu$m.

In one or more embodiments, along a width direction of the solar cell, a ratio of a width D2 of the first electrode to a width D1 of the first region satisfies: 0.3$\leq$D2/D1$\leq$1.

In one or more embodiments, the body further includes an emitter arranged on a surface of the substrate away from the first tunneling layer, and the solar cell further includes a second electrode electrically connected to the emitter.

In one or more embodiments, the body further includes a first passivation layer and a second passivation layer, the first passivation layer is arranged on a side of the first doped conductive layer away from the substrate, and the second passivation layer is arranged on a side of the emitter away from the substrate.

In one or more embodiments, the body further includes: a second tunneling layer, a third doped conductive layer, and a fourth doped conductive layer. The second tunneling layer is arranged on a side of the substrate away from the first tunneling layer, and the second tunneling layer has a greater thickness in the first region than in the second region. The third doped conductive layer is arranged on a surface of the second tunneling layer away from the substrate, and the fourth doped conductive layer is located on a side of the substrate close to the second tunneling layer, and the fourth doped conductive layer has a less thickness in the first region than in the second region.

The solar cell further includes a third electrode electrically connected to the third doped conductive layer.

In one or more embodiments, the body further includes a first passivation layer and a third passivation layer, the first passivation layer is arranged on a side of the first doped conductive layer away from the substrate, and the third passivation layer is arranged on a side of the third doped conductive layer away from the substrate.

Some embodiments of the present disclosure provide a photovoltaic module. The photovoltaic module includes: a solar cell string, an encapsulation layer, and a cover plate. The solar cell string includes a plurality of solar cells connected to one another, the encapsulation layer covers a surface of the solar cell string, and the cover plate covers a surface of the packaging layer away from the solar cell string.

The solar cell includes a body and a first electrode. The body has a first region and a second region. Along a thickness direction of the solar cell, at least part of the first region covers the first electrode. The second region is a region of the body other than the first region. The body includes a substrate, a first tunneling layer, a first doped conductive layer, and a second doped conductive layer. The first tunneling layer is arranged on a side of the substrate, and the first tunneling layer has a greater thickness in the first region than in the second region. The first doped conductive layer is arranged on a surface of the first tunneling layer away from the substrate, and the first electrode is electrically connected to the first doped conductive layer. The second doped conductive layer is located on a side of the substrate adjacent to the first tunneling layer, and the second doped conductive layer has a less thickness in the first region than in the second region.

It should be understood that the foregoing general description and the following detailed description are exemplary only and are not intended to limit the present disclosure.

BRIEF DESCRIPTION OF DRAWINGS

Fig. 1      is a schematic structural diagram of a solar cell according to some embodiments of the present disclosure;

Fig. 2      is a schematic structural diagram of the solar cell according to some embodiments of the present disclosure;

Fig. 3      is a schematic structural diagram of the solar cell according to some embodiments of the present disclosure;

Fig. 4      is a schematic structural diagram of the solar cell according to some embodiments of the present disclosure;

Fig. 5      is a schematic structural diagram of a photovoltaic module according to some embodiments of the present disclosure; and

Fig. 6      is a plan view of a solar cell according to some embodiments of the present disclosure.

Reference signs:

I: first region;
II: second region;
11: substrate;
12: first tunneling layer;
12': second tunneling layer;
13: first doped conductive layer;
13': third doped conductive layer;
14: second doped conductive layer;
14': fourth doped conductive layer;
15: first passivation layer;
15': third passivation layer;
16: emitter;
17: second passivation layer;
21: first electrode;
21': third electrode;
22: second electrode;
110: solar cell string;
120: encapsulation layer;
130: cover plate.

The accompanying drawings herein are incorporated in and constitute a part of this specification, illustrate embodiments consistent with the present disclosure and, together with the specification, serve to explain the principles of the present disclosure.

DESCRIPTION OF EMBODIMENTS

In order to better understand the technical solutions of the present disclosure, embodiments of the present disclosure are described in detail below with reference to the accompanying drawings.

It is to be made clear that the described embodiments are only some rather than all of the embodiments of the present disclosure. All other embodiments obtained by those of ordinary skill in the art based on the embodiments in the present disclosure without creative efforts fall within the protection scope of the present disclosure.

The terms used in the embodiments of the present disclosure are intended only to describe particular embodiments and are not intended to limit the present disclosure. As used in the embodiments of the present disclosure and the appended claims, the singular forms of "a/an", "the", and "said" are intended to include plural forms, unless otherwise clearly specified by the context.

It is to be understood that the term "and/or" used herein is merely an association relationship describing associated objects, indicating that three relationships may exist. For example, A and/or B indicates that there are three cases of A alone, A and B together, and B alone. In addition, the character "/" herein generally means that the associated objects are in an "or" relationship.

It is to be noted that the location terms such as "above", "below", "left", and "right" described in the embodiments of the present disclosure are described with reference to the angles shown in the accompanying drawings, and should not be construed as limitations on the embodiments of the present disclosure. In addition, in the context, it is to be further understood that, when one element is referred to as being connected "above" or "below" another element, the one element may be directly connected "above" or "below" another element, or connected "above" or "below" another element via an intermediate element.

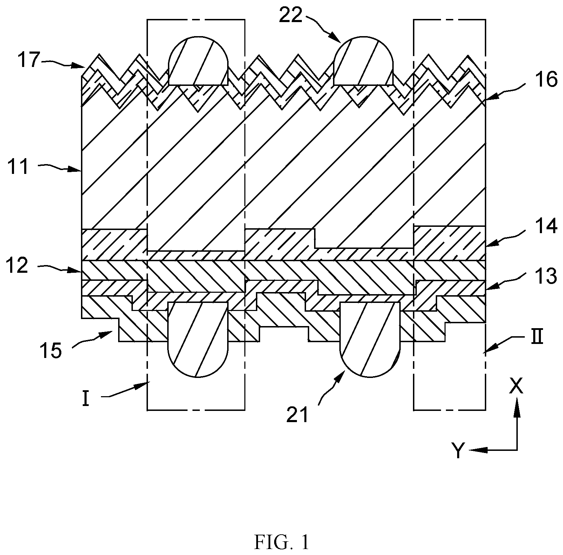

Embodiments of the present disclosure provide a solar cell. As shown in FIG. 1, the solar cell includes a body and a first electrode 21. The body has a first region I and a second region II. Along a thickness direction X of the solar cell, at least part of the first region I covers the first electrode 21. The thickness direction X of the solar cell is a direction perpendicular to the solar cell. The second region II is a region of the body other than the first region I. The body includes: a substrate 11, a first tunneling layer 12, a first doped conductive layer 13, and a second doped conductive layer 14. The first tunneling layer 12 is arranged on a side of the substrate 11, and a thickness of the first tunneling layer 12 in the first region I is greater than that in the second region II. The first doped conductive layer 13 is arranged on a surface of the first tunneling layer 12 away from the substrate 11, and the first electrode 21 is electrically connected to the first doped conductive layer 13. As shown in FIG. 1, the first electrode 21 is in contact with the first doped conductive layer 13. The second doped conductive layer 14 is located on a side of the substrate 11 adjacent to the first tunneling layer 12, and a thickness of the second doped conductive layer 14 in the first region I is less than that in the second region II.

In this embodiment, as shown in FIG. 1, the first tunneling layer 12 is a tunneling layer for majority carriers, and at the same time chemically passivates the substrate 11 to reduce interface states. The first doped conductive layer 13 can form energy band bending, realize selective transport of the carriers, and reduce recombination losses of the carriers. The first electrode 21 is electrically connected to the first doped conductive layer 13, and is not in contact with the first tunneling layer 12, thereby maintaining good interface passivation. A small part of the dopant element in the first doped conductive layer 13 may enter the substrate 11 by passing through the first tunneling layer 12, and form the second doped conductive layer 14 on a surface of the substrate 11. Since the thickness of the first tunneling layer 12 in the first region I is different from that in the second region II, the thickness of the second doped conductive layer 14 on the surface of the substrate 11 formed by the dopant element from the first doped conductive layer 13 is different.

As shown in FIG. 1, the thickness of the first tunneling layer 12 in the first region I is greater than that in the second region II, so that the thickness of the second doped conductive layer 14 in the first region I is less than that in the second region II. In the first region I, the first electrode 21 extends into the first doped conductive layer 13, which damages a structure of the first doped conductive layer 13 and increases recombination of carriers. A thicker first tunneling layer 12 is arranged on a side of the first electrode 21 adjacent to the substrate 11, which can improve a passivation effect of the first region, reduce the thickness of the second doped conductive layer 14, reduce the recombination of the carriers, and improve the photoelectric conversion efficiency of the solar cell. In the second region II, a thinner first tunneling layer 12 improves transport capability of the carriers from the substrate 11 to the first doped conductive layer 13, and makes the second doped conductive layer 14 thicker. As a result, the sheet resistance of the second doped conductive layer 14 is reduced, the transverse transport capability of the carriers in the second doped conductive layer 14 is improved, and the photoelectric conversion efficiency of the solar cell is improved.

For example, the substrate 11 may be a crystalline semiconductor (e.g., crystalline silicon) containing a dopant element. The dopant element may be an N-type dopant element such as a Group V element including phosphorus (P), arsenic (As), bismuth (Bi), and antimony (Sb), or a P-type dopant element such as a Group III element including boron (B), aluminum (Al), gallium (Ga), and indium (In). In one or more embodiments, the first tunneling layer 12 is a silicon oxide layer ($SiO_x$), with a thickness ranging from 0.5 nm to 2.5 nm. The thickness of the first tunneling layer 12 may be, for example, 0.5 nm, 1 nm, 1.5 nm, 2 nm, 2.5 nm, or the like. A material of the first electrode 21 includes at least one conductive metal material such as silver, aluminum, copper, nickel, or the like.

In addition, the photoelectric conversion efficiency of the solar cell may include a photoelectric conversion efficiency at a front surface of the solar cell and a photoelectric conversion efficiency at a back surface of the solar cell. In addition, a bifaciality of the solar cell may refer to a ratio of the photoelectric conversion efficiency at the back surface of the solar cell to the photoelectric conversion efficiency at the front surface of the solar cell. If the first doped conductive layer 13 is thicker, the first doped conductive layer 13 absorbs more light energy, and fewer light is received by the substrate 11, which affects the photoelectric conversion efficiency at the back surface of the solar cell and reduces the bifaciality of the solar cell. At the same time, if the first doped conductive layer 13 is thicker, the front efficiency of the solar cell can also be reduced.

In one or more embodiments, as shown in FIG. 1, the first tunneling layer 12 in the first region I protrudes towards the first doped conductive layer 13 with respect to the first tunneling layer 12 in the second region II, and the second doped conductive layer 14 in the second region II protrudes towards the substrate 11 with respect to the second doped conductive layer 14 in the first region I.

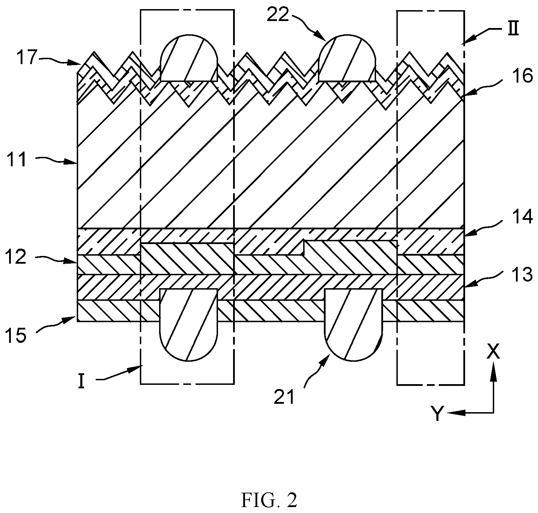

In one or more embodiments, as shown in FIG. 2, the first tunneling layer 12 in the first region I protrudes towards the substrate 11 with respect to the first tunneling layer 12 in the second region II, and the second doped conductive layer 14 in the second region II protrudes towards the first doped conductive layer 13 with respect to the second doped conductive layer 14 in the first region I.

As shown in FIG. 1, in one or more embodiments, the first tunneling layer 12 in the first region I protrudes towards the first doped conductive layer 13 with respect to the first tunneling layer 12 in the second region II, so that the second doped conductive layer 14 in the second region II protrudes towards the substrate 11 with respect to the second doped conductive layer 14 in the first region I. That is, an interface between the first tunneling layer 12 and the second doped conductive layer 14 is a substantially flat plane.

As shown in FIG. 2, in one or more embodiments, the first tunneling layer 12 in the first region I protrudes towards the substrate 11 with respect to the first tunneling layer 12 in the second region II, so that the second doped conductive layer 14 in the second region II protrudes towards the first doped conductive layer 13 with respect to the second doped conductive layer 14 in the first region I. That is, an interface between the first tunneling layer 12 and the first doped conductive layer 13 is a substantially flat plane, and a surface of the second doped conductive layer 14 away from the first tunneling layer 12 is a substantially flat plane.

In one or more embodiments, in the second doped conductive layer 14, a doping concentration of a dopant element in the first region I is less than that in the second region II.

In this embodiment, if the doping concentration of the dopant element in the second doped conductive layer 14 in the first region I is smaller, recombination of the carriers caused by the influence of the first electrode 21 on the body can be reduced. If the doping concentration of the dopant element in the second doped conductive layer 14 in the second region II is greater, resistance of the body can be reduced, and the transverse transport capability of the carriers can be improved, thereby improving the photoelectric conversion efficiency of the solar cell.

The dopant element in the second doped conductive layer 14 is from the first doped conductive layer 13, so the dopant element in the second doped conductive layer 14 is the same as the dopant element in the first doped conductive layer 13. The first doped conductive layer 13 may be amorphous silicon, microcrystalline silicon, polycrystalline silicon, or the like including the dopant element. The dopant element may be an N-type dopant element such as a Group V element including P, As, Bi, and Sb, or a P-type dopant element such as a Group III element including B, Al, Ga, and In. Moreover, the first doped conductive layer 13 and the substrate 11 are doped with a same type of dopant element.

In one or more embodiments, the doping concentration c1 of the dopant element of the second doped conductive layer 14 in the first region I satisfies: $1 \times 10^{13}$ atoms/$cm^3 \leq c1 \leq 1 \times 10^{20}$ atoms/$cm^3$. For example, the doping concentration c1 may be $1 \times 10^{13}$ atoms/$cm^3$, $0.5 \times 10^{19}$ atoms/$cm^3$, $1 \times 10^{19}$ atoms/$cm^3$, $0.5 \times 10^{20}$ atoms/$cm^3$, $1 \times 10^{20}$ atoms/$cm^3$, or the like.

In this embodiment, the doping concentration c1 of the dopant element of the second doped conductive layer 14 in the first region I should not be excessively large or excessively small. If the doping concentration c1 is excessively large (e.g., greater than $1 \times 10^{20}$ atoms/$cm^3$), recombination of the carriers of the second doped conductive layer 14 in the first region I increases, so that the efficiency of the solar cell cannot be effectively improved. If the doping concentration c1 is excessively small (e.g., less than $1 \times 10^{18}$ atoms/$cm^3$), the second doped conductive layer 14 cannot provide enough carriers, thereby affecting the efficiency of the solar cell. Therefore, when the doping concentration c1 of the dopant element of the second doped conductive layer 14 in the first region I satisfies: $1 \times 10^{13}$ atoms/$cm^3 \leq c1 \leq 1 \times 10^{20}$ atoms/$cm^3$, the efficiency of the solar cell can be effectively improved.

In one or more embodiments, the doping concentration c2 of the dopant element of the second doped conductive layer 14 in the second region II satisfies: $1 \times 10^{19}$ atoms/cm$^3 \leq c2 \leq 2 \times 10^{20}$ atoms/cm$^3$. For example, the doping concentration c2 may be $1 \times 10^{19}$ atoms/cm$^3$, $3 \times 10^{19}$ atoms/cm$^3$, $5 \times 10^{19}$ atoms/cm$^3$, $7 \times 10^{19}$ atoms/cm$^3$, $9 \times 10^{19}$ atoms/cm$^3$, $2 \times 10^{20}$ atoms/cm$^3$, or the like.

In this embodiment, the doping concentration c2 of the dopant element of the second doped conductive layer 14 in the second region II should not be excessively large or excessively small. If the doping concentration c2 is excessively large (e.g., greater than $2 \times 10^{20}$ atoms/cm$^3$), recombination of the carriers in the second region II of the second doped conductive layer 14 increases, so that the efficiency of the solar cell cannot be effectively improved. If the doping concentration c2 is excessively small (e.g., less than $1 \times 10^{19}$ atoms/cm$^3$), the second doped conductive layer 14 cannot provide enough carriers, thereby affecting the efficiency of the solar cell. Therefore, when the doping concentration c2 of the dopant element of the second doped conductive layer 14 in the second region II satisfies: $1 \times 10^{19}$ atoms/cm$^3 \leq c2 \leq 2 \times 10^{20}$ atoms/cm$^3$, the efficiency of the solar cell can be effectively improved.

In one or more embodiments, a thickness H11 of the first tunneling layer 12 in the first region I satisfies: 1 nm $\leq$ H11 $\leq$ 2.5 nm. For example, the thickness H11 may be 1 nm, 1.5 nm, 2 nm, 2.5 nm, or the like.

In this embodiment, the thickness H11 of the first tunneling layer 12 in the first region I should not be excessively large or excessively small. If the thickness H11 is excessively large (e.g., greater than 2.5 nm), a tunneling probability of the carriers in the substrate 11 passing through the first tunneling layer 12 is reduced, which affects the efficiency of the solar cell. If the thickness H11 is excessively small (e.g., less than 1 nm), the difficulty for the dopant element in the first doped conductive layer 13 to pass through the first tunneling layer 12 is reduced, so that the thickness of the second doped conductive layer 14 in the first region I increases, and the recombination of the carriers increases, thereby affecting the efficiency of the solar cell. Therefore, when the thickness H11 of the first tunneling layer 12 in the first region I satisfies: 1 nm $\leq$ H11 $\leq$ 2.5 nm, the efficiency of the solar cell can be effectively improved.

In one or more embodiments, a thickness H12 of the first tunneling layer 12 in the second region II satisfies: 0.5 nm $\leq$ H12 $\leq$ 2 nm. For example, the thickness H12 may be 0.5 nm, 1 nm, 1.5 nm, 2 nm, or the like.

In this embodiment, the thickness H12 of the first tunneling layer 12 in the second region II should not be excessively large or excessively small. If the thickness H12 is excessively large (e.g., greater than 2 nm), the difficulty for the dopant element in the first doped conductive layer 13 to pass through the first tunneling layer 12 is increased, so that the thickness of the second doped conductive layer 14 in the second region II decreases, and the resistance of the second doped conductive layer 14 increases, which affects the transverse transport capability of the carriers. If the thickness H12 is excessively small (e.g., less than 0.5 nm), the first tunneling layer 12 has a poor passivation effect on the substrate 11, and the recombination of the carriers increases, thereby affecting the efficiency of the solar cell. Therefore, when the thickness H12 of the first tunneling layer 12 in the second region II satisfies: 0.5 nm $\leq$ H12 $\leq$ 2 nm, the efficiency of the solar cell can be effectively improved.

In one or more embodiments, a thickness H21 of the second doped conductive layer 14 in the first region I satisfies: 0 $\mu$m $\leq$ H21 $\leq$ 0.5 $\mu$m. For example, the thickness H21 may be 0 $\mu$m, 0.1 $\mu$m, 0.2 $\mu$m, 0.3 $\mu$m, 0.4 $\mu$m, 0.5 $\mu$m, or the like.

In this embodiment, the thickness H21 of the second doped conductive layer 14 in the first region I should not be excessively large. If the thickness H21 is excessively large (e.g., greater than 0.5 $\mu$m), recombination of the carriers in the region increases, which affects the efficiency of the solar cell. In addition, the solar cell may not include the second doped conductive layer 14.

In one or more embodiments, as shown in the figure, a thickness H22 of the second doped conductive layer 14 in the second region II satisfies: 0 $\mu$m $\leq$ H22 $\leq$ 1 $\mu$m. For example, the thickness H22 may be 0 $\mu$m, 0.2 $\mu$m, 0.4 $\mu$m, 0.6 $\mu$m, 0.8 $\mu$m, 1 $\mu$m, or the like.

In this embodiment, the thickness H22 of the second doped conductive layer 14 in the second region II should not be excessively large. If the thickness H22 is excessively large (e.g., greater than 1 $\mu$m), recombination of the carriers in the region may also increase, which affects the efficiency of the solar cell.

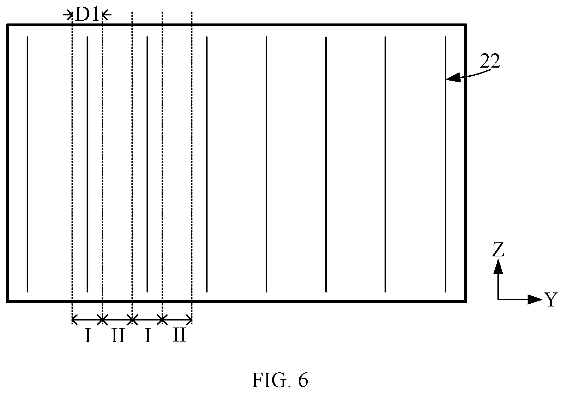

FIG. 6 is a plan view of a solar cell according to some embodiments of the present disclosure. As shown in FIG. 1 and FIG. 6, the body has multiple first regions I and multiple second regions II, and the first regions I are arranged alternately with the second regions II along a width direction Y of the solar cell.

In this embodiment, the first region I and the second region II are spaced apart along the width direction Y of the solar cell, so that the first region I corresponds to the first electrode 21, thereby effectively reducing an increase in the carrier recombination caused by damages of the first doped conductive layer 13 caused by the first electrode 21 and ensuring the efficiency of the solar cell.

In one or more embodiments, as shown in FIG. 6, along the width direction Y of the solar cell, a width D1 of the first region I satisfies: 10 $\mu$m $\leq$ D1 $\leq$ 200 $\mu$m. For example, the width D1 may be 10 $\mu$m, 20 $\mu$m, 50 $\mu$m, 100 $\mu$m, 150 $\mu$m, 200 $\mu$m, or the like. FIG. 6 also shows the length direction Z of the solar cell, and the second electrode 22 extends along the length direction Z.

In this embodiment, along the width direction Y of the solar cell, the width D1 of the first region I should not be excessively large or excessively small. If the width D1 is excessively large (e.g., greater than 200 $\mu$m), the width

of the second region II is excessively small, which affects the transverse transport capability of the solar cell. If the width D1 is excessively small (e.g., less than 10 μm), the first region I cannot completely cover the first electrode 21 along a thickness direction X of the solar cell, so that the recombination of the carriers cannot be effectively reduced, which affects the efficiency of the solar cell.

In one or more embodiments, along the width direction Y of the solar cell, a ratio of a width D2 of the first electrode 21 to a width D1 of the first region I satisfies: 0.3≤D2/D1≤1. For example, the ratio of the width D2 to the width D1 may be 0.3, 0.5, 0.7, 0.9, 1, or the like.

In this embodiment, along the width direction Y of the solar cell, the ratio of the width D2 of the first electrode 21 to the width D1 of the first region I should not be excessively large or excessively small. If the ratio of the width D2 to the width D1 is excessively large (e.g., greater than 1), the first region I cannot completely cover the first electrode 21 along the thickness direction X of the solar cell, so that the recombination of the carriers cannot be effectively reduced, which affects the efficiency of the solar cell. If the ratio of the width D2 to the width D1 is excessively small (e.g., less than 0.3), the width D1 of the first region I is excessively large, and the width of the second region II is excessively small, which affects the transverse transport capability of the solar cell. Therefore, when, along the width direction Y of the solar cell, the ratio of a width D2 of the first electrode 21 to the width D1 of the first region I satisfies: 0.3≤D2/D1≤1, the transport capability of the solar cell can be ensured.

In one or more embodiments, as shown in FIG. 1 and FIG. 2, the body further includes an emitter 16 arranged on a surface of the substrate 11 away from the first tunneling layer 12, and the solar cell further includes a second electrode 22 electrically connected to the emitter 16.

In this embodiment, as shown in FIG. 1 and FIG. 2, the substrate 11 and the emitter 16 can jointly form a PN junction structure. The substrate 11 may be a P-type silicon substrate, the emitter 16 may be an N-type emitter, and the P-type silicon substrate and the N-type emitter may jointly form a built-in electric field of the PN junction. In some other embodiments, the substrate 11 may be an N-type silicon substrate, while the emitter 16 may be a P-type emitter.

In one or more embodiments, as shown in FIG. 1 and FIG. 2, the body further includes a first passivation layer 15 and a second passivation layer 17, the first passivation layer 15 is arranged on a side of the first doped conductive layer 13 away from the substrate 11, and the second passivation layer 17 is arranged on a side of the emitter 16 away from the substrate 11.

In this embodiment, as shown in FIG. 1 and FIG. 2, the first passivation layer 15 can passivate a surface of the first doped conductive layer 13 away from the substrate 11, and the second passivation layer 17 can passivate a surface of the emitter 16 away from the substrate 11, thereby reducing a recombination rate of the carriers of the first doped conductive layer 13 and a recombination rate of the carriers of the emitter 16 respectively, and improving the photoelectric conversion efficiency of the solar cell.

For example, each of the first passivation layer 15 and the second passivation layer 17 may be a single layer such as a silicon oxide layer, a silicon nitride layer, an aluminum oxide layer, and a silicon oxynitride layer. For another example, each of the first passivation layer 15 and the second passivation layer 17 may be a stacked structure including at least one or more of a silicon oxide layer, a silicon nitride layer, an aluminum oxide layer, and a silicon oxynitride layer.

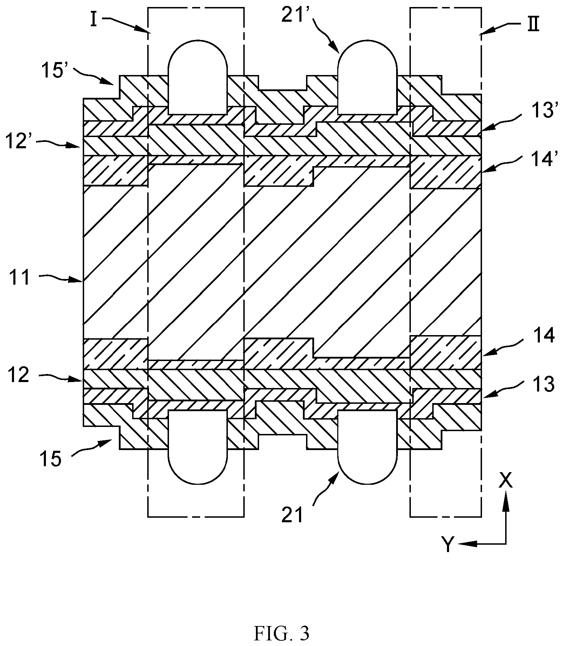

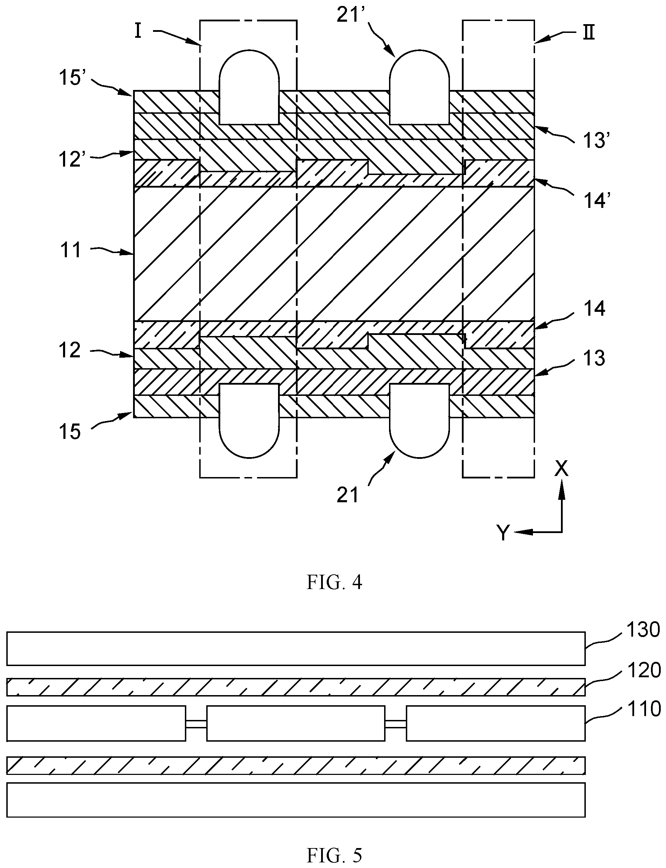

In one or more embodiments, as shown in FIG. 3 and FIG. 4, the body further includes: a second tunneling layer 12', a third doped conductive layer 13', and a fourth doped conductive layer 14'. The second tunneling layer 12' is arranged on a side of the substrate 11 away from the first tunneling layer 12, and a thickness of the second tunneling layer 12' in the first region I is greater than that in the second region II. The third doped conductive layer 13' is arranged on a surface of the second tunneling layer 12' away from the substrate 11. The fourth doped conductive layer 14' is located on a side of the substrate 11 adjacent to the second tunneling layer 12', and a thickness of the fourth doped conductive layer 14' in the first region I is less than that in the second region II. The solar cell further includes a third electrode 21', and the third electrode 21' is electrically connected to the third doped conductive layer 13'.

In this embodiment, as shown in FIG. 3 and FIG. 4, the second tunneling layer 12' is a tunneling layer for majority carriers, and at the same time chemically passivates the substrate 11 to reduce interface states. The third doped conductive layer 13' can form energy band bending, realize selective transport of the carriers, and reduce recombination losses of the carriers. The third electrode 21' is electrically connected to the third doped conductive layer 13', and is not in contact with the second tunneling layer 12', thereby maintaining good interface passivation. A small part of the dopant element in the third doped conductive layer 13' may enter the substrate 11 through the second tunneling layer 12', and form the fourth doped conductive layer 14' on a surface of the substrate 11. The thickness of the second tunneling layer 12' in the first region I is different from that in the second region II, so that the thickness of the fourth doped conductive layer 14' formed on the surface of the substrate 11 and formed by the dopant element from the third doped conductive layer 13' is different.

As shown in FIG. 3, the thickness of the second tunneling layer 12' in the first region I is greater than that in the second region II, so that the thickness of the fourth doped conductive layer 14' in the first region I is less than that in the second region II. In the first region I, the third electrode 21' extends into the third doped conductive layer 13', which damages a structure of the third doped conductive layer 13' and increases carrier recombination. A thicker second tunneling layer 12' is arranged on a side of the third electrode 21' adjacent to the substrate 11, which can improve a passivation effect of the region, reduce the thickness of the fourth doped conductive layer 14', reduce the carrier recombination, and improve the photoelectric conversion efficiency of the solar cell. In the second region II, the thinner second tunneling layer 12' improves transport capability of the carriers from the substrate 11 to the third doped conductive layer 13', and makes the fourth doped conductive layer 14' thicker, which reduces sheet resistance of the fourth doped conductive layer 14', improves the transverse transport capability of the carriers, and improves the photoelectric conversion efficiency of the solar cell. For example, the second tunneling layer 12' is a silicon oxide layer ($SiO_x$), with a thickness ranging from 0.5 nm to 2.5 nm. For example, the thickness of the second tunneling layer 12' may be 0.5 nm, 1 nm, 1.5 nm, 2 nm, 2.5 nm, or the like. The third doped conductive layer 13' may be amorphous silicon, microcrystalline silicon, polycrystalline silicon, or the like containing a dopant element. The dopant element may be an N-type dopant element such as a Group V element including P, As, Bi, and Sb, or a P-type dopant element such as a Group III element including B, Al, Ga, and In. Moreover, the third doped conductive layer 13' and the substrate 11 should be doped with different types of dopant elements, so that the third doped conductive layer 13' and the substrate 11 together form a built-in electric field structure that functions as a PN junction.

In one or more embodiments, as shown in FIG. 3 and FIG. 4, the body further includes a first passivation layer 15 and a third passivation layer 15', the first passivation layer 15 is arranged on a side of the first doped conductive layer 13 away from the substrate 11, and the third passivation layer 15' is arranged on a side of the third doped conductive layer 13' away from the substrate 11.

In this embodiment, as shown in FIG. 3 and FIG. 4, the first passivation layer 15 can passivate a surface of the first doped conductive layer 13 away from the substrate 11, thereby reducing a recombination rate of the carriers of the first doped conductive layer 13, and improving the photoelectric conversion efficiency of the solar cell. The third passivation layer 15' can passivate a surface of the third doped conductive layer 13' away from the substrate 11, thereby reducing a recombination rate of the carriers of the third doped conductive layer 13', and improving the photoelectric conversion efficiency of the solar cell.

For example, each of the first passivation layer 15 and the third passivation layer 15' may be a single layer such as a silicon oxide layer, a silicon nitride layer, an aluminum oxide layer, and a silicon oxynitride layer. For another example, each of the first passivation layer 15 and the third passivation layer 15' may be a stacked structure including at least one or more of a silicon oxide layer, a silicon nitride layer, an aluminum oxide layer, and a silicon oxynitride layer.

In one or more embodiments, as shown in FIG. 3, the second tunneling layer 12' in the first region I protrudes towards the third doped conductive layer 13' with respect to the second tunneling layer 12' in the second region II; and the fourth doped conductive layer 14' in the second region II protrudes towards the substrate 11 with respect to the fourth doped conductive layer 14' in the first region I.

In one or more embodiments, as shown in FIG. 3, the second tunneling layer 12' in the first region I protrudes towards the substrate 11 with respect to the second tunneling layer 12' in the second region II; and the fourth doped conductive layer 14' in the second region II protrudes towards the third doped conductive layer 13' with respect to the fourth doped conductive layer 14' in the first region I.

As shown in FIG. 3, in one or more embodiments, the second tunneling layer 12' in the first region I protrudes towards the third doped conductive layer 13' with respect to the second tunneling layer 12' in the second region II, so that the fourth doped conductive layer 14' in the second region II protrudes towards the substrate 11 with respect to the fourth doped conductive layer 14' in the first region I. That is, an interface between the second tunneling layer 12' and the fourth doped conductive layer 14' is a substantially flat plane.

As shown in FIG. 4, in one or more embodiments, the second tunneling layer 12' in the first region I protrudes towards the substrate 11 with respect to the second tunneling layer 12' in the second region II, so that the fourth doped conductive layer 14' in the second region II protrudes towards the third doped conductive layer 13' with respect to the fourth doped conductive layer 14' in the first region I. That is, an interface between the second tunneling layer 12' and the third doped conductive layer 13' is a substantially flat plane, and a surface of the fourth doped conductive layer 14' away from the second tunneling layer 12' is a substantially flat plane.

Some embodiments of the present disclosure provide a photovoltaic module. As shown in FIG. 5, the photovoltaic module includes: a solar cell string 110, an encapsulation layer 120, and a cover plate 130. The solar cell string 110 includes a plurality of solar cells connected to one another. The encapsulation layer 120 is configured to cover a surface of the solar cell string 110. As shown in FIG. 5, the encapsulation layer 120 covers at least the top and bottom surfaces of the solar cell string 110. The cover plate 130 is configured to cover a surface of the encapsulation layer 120 away from the solar cell string 110.

In this embodiment, as shown in FIG. 5, the plurality of solar cells in the solar cell string 110 are electrically connected in series and/or in parallel. The cover plate 130, the encapsulation layer 120, and the solar cell string 110 may be laminated in a certain order through a lamination process to obtain a laminated assembly, and then a frame may be mounted on the laminated assembly to form the photovoltaic module, which is easy to transport and use.

The above are merely preferred embodiments of the present disclosure and are not intended to limit the present disclosure. For those skilled in the art, the present disclosure may be subject to various changes and variations.

## Claims

1. A solar cell comprising: a body and a first electrode (21), the body having a first region (I) and a second region (II), wherein along a thickness direction (X) of the solar cell, at least part of the first region (I) covers the first electrode (21), and the second region (II) is a region of the body other than the first region (I), wherein the body comprises:

   a substrate (11);
   a first tunneling layer (12) arranged on a side of the substrate (11), wherein the first tunneling layer (12) has a greater thickness in the first region (I) than in the second region (II); and
   a first doped conductive layer (13) arranged on a surface of the first tunneling layer (12) away from the substrate (11), and electrically connected to the first electrode (21);
   **characterized in that**,
   the body further comprises a second doped conductive layer (14) arranged on a side of the substrate (11) adjacent to the first tunneling layer (12), wherein a dopant element in the second doped conductive layer (14) is from the first doped conductive layer (13), and the second doped conductive layer (14) has a lower thickness in the first region (I) than that in the second region (II).

2. The solar cell according to claim 1, wherein the first tunneling layer (12) in the first region (I) protrudes towards the first doped conductive layer (13) with respect to the first tunneling layer (12) in the second region (II); and
   the second doped conductive layer (14) in the second region (II) protrudes towards the substrate (11) with respect to the second doped conductive layer (14) in the first region (I).

3. The solar cell according to claim 1, wherein the first tunneling layer (12) in the first region (I) protrudes towards the substrate (11) with respect to the first tunneling layer (12) in the second region (II); and
   the second doped conductive layer (14) in the second region (II) protrudes towards the first doped conductive layer (13) with respect to the second doped conductive layer (14) in the first region (I).

4. The solar cell according to claim 1, wherein, in the second doped conductive layer (14), a doping concentration of a dopant element in the first region (I) is less than that in the second region (II).

5. The solar cell according to claim 4, wherein the doping concentration c1 of the dopant element in the first region (I) of the second doped conductive layer (14) satisfies: $1 \times 10^{13}$ atoms/cm$^3 \leq c1 \leq 1 \times 10^{20}$ atoms/cm$^3$, or the doping concentration c2 of the dopant element in the second region (II) of the second doped conductive layer (14) satisfies: $1 \times 10^{19}$ atoms/cm$^3 \leq c2 \leq 2 \times 10^{20}$ atoms/cm$^3$.

6. The solar cell according to claim 1, wherein a thickness H11 of the first tunneling layer (12) in the first region (I) satisfies: 1 nm $\leq$ H11 $\leq$ 2.5 nm, or a thickness H12 of the first tunneling layer (12) in the second region (II) satisfies: 0.5 nm $\leq$ H12 $\leq$ 2 nm.

7. The solar cell according to claim 1, wherein a thickness H21 of the second doped conductive layer (14) in the first region (I) satisfies: 0 $\mu$m < H21 $\leq$ 0.5 $\mu$m, or a thickness H22 of the second doped conductive layer (14) in the second region (II) satisfies: 0 $\mu$m < H22 $\leq$ 1 $\mu$m.

8. The solar cell according to claim 1, wherein the first region (I) is arranged alternately with the second region (II) along a width direction (Y) of the solar cell.

9. The solar cell according to claim 1, wherein, along a width direction (Y) of the solar cell, a width D1 of the first region (I) satisfies: 10 $\mu$m $\leq$ D1 $\leq$ 200 $\mu$m.

10. The solar cell according to claim 1, wherein, along a width direction (Y) of the solar cell, a ratio of a width D2 of the first electrode (21) to a width D1 of the first region (I) satisfies:

$$0.3 \leq D2/D1 \leq 1.$$

11. The solar cell according to claim 1, wherein the body further comprises an emitter (16) arranged on a surface of the substrate (11) away from the first tunneling layer (12), and
    the solar cell further comprises a second electrode (22) electrically connected to the emitter (16).

12. The solar cell according to claim 11, wherein the body further comprises:

    a first passivation layer (15) arranged on a side of the first doped conductive layer (13) away from the substrate (11); and
    a second passivation layer (17) arranged on a side of the emitter (16) away from the substrate (11).

13. The solar cell according to claim 1, wherein the body further comprises:

a second tunneling layer (12') arranged on a side of the substrate (11) away from the first tunneling layer (12), wherein the second tunneling layer (12') has a greater thickness in the first region (I) than in the second region (II); a third doped conductive layer (13') arranged on a surface of the second tunneling layer (12') away from the substrate (11); and a fourth doped conductive layer (14') located on a side of the substrate (11) adjacent to the second tunneling layer (12'), wherein the fourth doped conductive layer (14') has a lower thickness in the first region (I) than in the second region (II),

wherein the solar cell further comprises a third electrode (21') electrically connected to the third doped conductive layer (13').

14. The solar cell according to claim 13, wherein the body further comprises:

a first passivation layer (15) arranged on a side of the first doped conductive layer (13) away from the substrate (11); and a third passivation layer (15') arranged on a side of the third doped conductive layer (13') away from the substrate (11).

15. A photovoltaic module comprising:

a solar cell string (110) comprising a plurality of solar cells connected to one another; an encapsulation layer (120) configured to cover a surface of the solar cell string (110); and a cover plate (130) configured to cover a surface of the encapsulation layer (120) away from the solar cell string (110),

wherein the plurality of solar cells comprise at least one solar cell according to any of claims 1 to 14.

**Patentansprüche**

1. Solarzelle, umfassend: einen Körper und eine erste Elektrode (21), wobei der Körper einen ersten Bereich (I) und einen zweiten Bereich (II) aufweist, wobei mindestens ein Teil des ersten Bereichs (I) die erste Elektrode (21) entlang einer Dickenrichtung (X) der Solarzelle bedeckt und der zweite Bereich (II) ein anderer Bereich des Körpers ist als der erste Bereich (I),

wobei der Körper Folgendes umfasst:

ein Substrat (11);

eine erste Tunnelschicht (12), die auf einer Seite des Substrats (11) angeordnet ist, wobei die erste Tunnelschicht (12) im ersten Bereich (I) eine größere Dicke als im zweiten Bereich (II) aufweist; und eine erste dotierte leitfähige Schicht (13), die auf einer von dem Substrat (11) gegenüberliegenden Oberfläche der ersten Tunnelschicht (12) angeordnet und elektrisch mit der ersten Elektrode (21) verbunden ist; **dadurch gekennzeichnet ist, dass** der Körper ferner eine zweite dotierte leitfähige Schicht (14) umfasst, die auf einer an die erste Tunnelschicht (12) angrenzenden Seite des Substrats (11) angeordnet ist, wobei ein Dotierungselement in der zweiten dotierten leitfähigen Schicht (14) aus der ersten dotierten leitfähigen Schicht (13) stammt und die zweite dotierte leitfähige Schicht (14) im ersten Bereich (I) eine geringere Dicke als im zweiten Bereich (II) aufweist.

2. Solarzelle nach Anspruch 1, wobei die erste Tunnelschicht (12) im ersten Bereich (I) gegenüber der ersten Tunnelschicht (12) im zweiten Bereich (II) in Richtung der ersten dotierten leitfähigen Schicht (13) vorsteht; und die zweite dotierte leitfähige Schicht (14) im zweiten Bereich (II) gegenüber der zweiten dotierten leitfähigen Schicht (14) im ersten Bereich (I) in Richtung des Substrats (11) vorsteht.

3. Solarzelle nach Anspruch 1, wobei die erste Tunnelschicht (12) im ersten Bereich (I) gegenüber der ersten Tunnelschicht (12) im zweiten Bereich (II) in Richtung des Substrats (11) vorsteht; und die zweite dotierte leitfähige Schicht (14) im zweiten Bereich (II) gegenüber der zweiten dotierten leitfähigen Schicht (14) im ersten Bereich (I) in Richtung der ersten dotierten leitfähigen Schicht (13) vorsteht.

4. Solarzelle nach Anspruch 1, wobei in der zweiten dotierten leitfähigen Schicht (14) die Dotierungskonzentration eines Dotierungselements im ersten Bereich (I) geringer ist als im zweiten Bereich (II).

5. Solarzelle nach Anspruch 4, wobei für die Dotierungskonzentration c1 des Dotierungselements im ersten Bereich (I) der zweiten dotierten leitfähigen Schicht (14) $1\times10^{18}$ Atome/cm$^3$ ≤ c1 ≤ $1\times10^{20}$ Atome/cm$^3$ gilt oder für die Dotierungskonzentration c2 des Dotierungselements im zweiten Bereich (II) der zweiten dotierten leitfähigen Schicht (14) $1\times10^{19}$ Atome/cm$^3$ ≤ c2 ≤ $2\times10^{20}$ Atome/cm$^3$ gilt.

6. Solarzelle nach Anspruch 1, wobei für eine Dicke H11 der ersten Tunnelschicht (12) im ersten Bereich (I) 1 nm ≤ H11 ≤ 2,5 nm gilt oder für eine Dicke H12 der ersten Tunnelschicht (12) im zweiten Bereich (II) 0,5 nm ≤ H12 ≤ 2 nm gilt.

7. Solarzelle nach Anspruch 1, wobei für eine Dicke H21 der zweiten dotierten leitfähigen Schicht (14) im ersten Bereich (I) 0 $\mu$m < H21 ≤ 0,5 $\mu$m gilt oder für eine Dicke H22 der zweiten dotierten leitfähigen Schicht (14) im zweiten Bereich (II) 0 $\mu$m < H22 ≤ 1 $\mu$m gilt.

8. Solarzelle nach Anspruch 1, wobei der erste Bereich (I) entlang einer Breitenrichtung (Y) der Solarzelle abwechselnd mit dem zweiten Bereich (II) angeordnet ist.

9. Solarzelle nach Anspruch 1, wobei für eine Breite D1 des ersten Bereichs (I) entlang einer Breitenrichtung (Y) der Solarzelle 10 $\mu$m ≤ D1 ≤ 200 $\mu$m gilt.

10. Solarzelle nach Anspruch 1, wobei für ein Verhältnis einer Breite D2 der ersten Elektrode (21) zu einer Breite D1 des ersten Bereichs (I) entlang einer Breitenrichtung (Y) der Solarzelle 0,3 ≤ D2/D1 ≤ 1 gilt.

11. Solarzelle nach Anspruch 1, wobei der Körper ferner einen auf einer der ersten Tunnelschicht (12) gegenüberliegenden Oberfläche des Substrats (11) angeordneten Emitter (16) umfasst und die Solarzelle ferner eine zweite Elektrode (22), die elektrisch mit dem Emitter (16) verbunden ist, umfasst.

12. Die Solarzelle nach Anspruch 11, wobei der Körper ferner Folgendes umfasst:

   eine erste Passivierungsschicht (15), die auf einer dem Substrat (11) gegenüberliegenden Seite der ersten dotierten leitfähigen Schicht (13) angeordnet ist; und eine zweite Passivierungsschicht (17), die einer dem Substrat (11) gegenüberliegenden Seite des Emitters (16) angeordnet ist.

13. Die Solarzelle nach Anspruch 1, wobei der Körper ferner Folgendes umfasst:

   eine zweite Tunnelschicht (12'), die auf einer der ersten Tunnelschicht (12) gegenüberliegenden Seite des Substrats (11) angeordnet ist, wobei die zweite Tunnelschicht (12') im ersten Bereich (I) eine größere Dicke als im zweiten Bereich (II) aufweist; eine dritte dotierte leitfähige Schicht (13'), die auf einer dem Substrat (11) gegenüberliegenden Oberfläche der zweiten Tunnelschicht (12') angeordnet ist; und eine vierte dotierte leitfähige Schicht (14'), die sich auf einer an die zweite Tunnelschicht (12') angrenzenden Seite des Substrats (11) befindet, wobei die vierte dotierte leitfähige Schicht (14') im ersten Bereich (I) eine geringere Dicke als im zweiten Bereich (II) aufweist, wobei die Solarzelle ferner eine dritte Elektrode (21'), die elektrisch mit der dritten dotierten leitfähigen Schicht (13') verbunden ist, umfasst.

14. Die Solarzelle nach Anspruch 13, wobei der Körper ferner Folgendes umfasst:

   eine erste Passivierungsschicht (15), die auf einer dem Substrat (11) gegenüberliegenden Seite der ersten dotierten leitfähigen Schicht (13) angeordnet ist; und eine dritte Passivierungsschicht (15'), die auf einer dem Substrat (11) gegenüberliegenden Seite der dritten dotierten leitfähigen Schicht (13') angeordnet ist.

15. Photovoltaikmodul, umfassend:

   einen Solarzellenstring (110), der eine Vielzahl von miteinander verbundenen Solarzellen umfasst; eine Verkapselungsschicht (120), die so ausgebildet ist, dass sie eine Oberfläche des Solarzellenstrings (110) bedeckt; und eine Abdeckplatte (130), die so ausgebildet ist, dass sie eine dem Solarzellenstring (110) gegenüberliegende Oberfläche der Verkapselungsschicht (120) abdeckt, wobei die Vielzahl von Solarzellen mindestens eine Solarzelle nach einem der Ansprüche 1 bis 14 umfasst.

**Revendications**

1. Cellule solaire comprenant : un corps et une première électrode (21), le corps ayant une première région (I) et une deuxième région (II), dans laquelle, dans une direction d'épaisseur (X) de la cellule solaire, au moins une partie de la première région (I) recouvre la première électrode (21), et la deuxième région (II) est une région du corps autre que la première région (I), dans laquelle le corps comprend :

   un substrat (11) ; une première couche à effet tunnel (12) disposée sur un côté du substrat (11), la première couche à effet tunnel (12) ayant une épaisseur plus grande dans la première région (I) que dans la deuxième région (II) ; et une première couche conductrice dopée (13) disposée sur une surface de la première couche à effet tunnel (12) à l'opposé du substrat (11), et électriquement connectée à la première électrode (21) ;

**caractérisée en ce que**

le corps comprend en outre une deuxième couche conductrice dopée (14) disposée sur un côté du substrat (11) adjacent à la première couche à effet tunnel (12), dans laquelle un élément dopant dans la deuxième couche conductrice dopée (14) provient de la première couche conductrice dopée (13), et la deuxième couche conductrice dopée (14) a une plus petite épaisseur dans la première région (I) que dans la deuxième région (II).

2. Cellule solaire selon la revendication 1, dans laquelle la première couche à effet tunnel (12) dans la première région (I) fait saillie vers la première couche conductrice dopée (13) par rapport à la première couche à effet tunnel (12) dans la deuxième région (II) ; et
la deuxième couche conductrice dopée (14) dans la deuxième région (II) fait saillie vers le substrat (11) par rapport à la deuxième couche conductrice dopée (14) dans la première région (I).

3. Cellule solaire selon la revendication 1, dans laquelle la première couche à effet tunnel (12) dans la première région (I) fait saillie vers le substrat (11) par rapport à la première couche à effet tunnel (12) dans la deuxième région (II) ; et
la deuxième couche conductrice dopée (14) dans la deuxième région (II) fait saillie vers la première couche conductrice dopée (13) par rapport à la deuxième couche conductrice dopée (14) dans la première région (I).

4. Cellule solaire selon la revendication 1, dans laquelle, dans la deuxième couche conductrice dopée (14), une concentration de dopage d'un élément dopant dans la première région (I) est inférieure à celle dans la deuxième région (II).

5. Cellule solaire selon la revendication 4, dans laquelle la concentration de dopage c1 de l'élément dopant dans la première région (I) de la deuxième couche conductrice dopée (14) satisfait : $1 \times 10^{13}$ atomes/cm$^3$ ≤ c1 ≤ $1 \times 10^{20}$ atomes/cm$^3$, ou la concentration de dopage c2 de l'élément dopant dans la deuxième région (II) de la deuxième couche conductrice dopée (14) satisfait : $1 \times 10^{19}$ atomes/cm$^3$ ≤ c2 ≤ $2 \times 10^{20}$ atomes/cm$^3$.

6. Cellule solaire selon la revendication 1, dans laquelle une épaisseur H11 de la première couche à effet tunnel (12) dans la première région (I) satisfait : 1 nm ≤ H11 ≤ 2,5 nm, ou une épaisseur H12 de la première couche à effet tunnel (12) dans la deuxième région (II) satisfait : 0,5 nm ≤ H12 ≤ 2 nm.

7. Cellule solaire selon la revendication 1, dans laquelle une épaisseur H21 de la deuxième couche conductrice dopée (14) dans la première région (I) satisfait : 0 μm < H21 ≤ 0,5 μm, ou une épaisseur H22 de la deuxième couche conductrice dopée (14) dans la deuxième région (II) satisfait : 0 μm < H22 ≤ 1 μm.

8. Cellule solaire selon la revendication 1, dans laquelle la première région (I) est disposée en alternance avec la deuxième région (II) dans une direction de largeur (Y) de la cellule solaire.

9. Cellule solaire selon la revendication 1, dans laquelle, dans une direction de largeur (Y) de la cellule solaire, une largeur D1 de la première région (I) satisfait : 10 μm ≤ D1 ≤ 200 μm.

10. Cellule solaire selon la revendication 1, dans laquelle, dans une direction de largeur (Y) de la cellule solaire, un rapport d'une largeur D2 de la première électrode (21) à une largeur D1 de la première région (I) satisfait : 0,3 ≤ D2/D1 ≤ 1.

11. Cellule solaire selon la revendication 1, dans laquelle le corps comprend en outre un émetteur (16) disposé sur une surface du substrat (11) à l'opposé de la première couche à effet tunnel (12), et la cellule solaire comprend en outre une deuxième électrode (22) connectée électriquement à l'émetteur (16).

12. Cellule solaire selon la revendication 11, dans laquelle le corps comprend en outre :

une première couche de passivation (15) disposée sur un côté de la première couche conductrice dopée (13) à l'opposé du substrat (11) ; et
une deuxième couche de passivation (17) disposée sur un côté de l'émetteur (16) à l'opposé du substrat (11).

13. Cellule solaire selon la revendication 1, dans laquelle le corps comprend en outre :

une deuxième couche à effet tunnel (12') disposée sur un côté du substrat (11) à l'opposé de la première couche à effet tunnel (12), la deuxième couche à effet tunnel (12') ayant une épaisseur plus grande dans la première région (I) que dans la deuxième région (II) ;
une troisième couche conductrice dopée (13') disposée sur une surface de la deuxième couche à effet tunnel (12') à l'opposé du substrat (11) ; et
une quatrième couche conductrice dopée (14') située sur un côté du substrat (11) adjacent à la deuxième couche à effet tunnel (12'), la quatrième couche conductrice dopée (14') ayant une plus petite épaisseur dans la première région (I) que dans la deuxième région (II), la cellule solaire comprenant en outre une troisième électrode (21') connectée électriquement à la troisième couche conductrice dopée (13').

**14.** Cellule solaire selon la revendication 13, dans laquelle le corps comprend en outre :

une première couche de passivation (15) disposée sur un côté de la première couche conductrice dopée (13) à l'opposé du substrat (11) ; et
une troisième couche de passivation (15') disposée sur un côté de la troisième couche conductrice dopée (13') à l'opposé du substrat (11).

**15.** Module photovoltaïque comprenant :

une chaîne de cellules solaires (110) comprenant une pluralité de cellules solaires connectées les unes aux autres ;
une couche d'encapsulation (120) configurée pour couvrir une surface de la chaîne de cellules solaires (110) ; et
une plaque de couverture (130) configurée pour couvrir une surface de la couche d'encapsulation (120) à l'opposé de la chaîne de cellules solaires (110),
la pluralité de cellules solaires comprenant au moins une cellule solaire selon l'une quelconque des revendications 1 à 14.

FIG. 1

FIG. 2

FIG. 3

FIG. 4

FIG. 5

FIG. 6

**REFERENCES CITED IN THE DESCRIPTION**

**Patent documents cited in the description**

- US 2022140160 A1